# EUROPÄISCHE PATENTANMELDUNG

(11) **EP 1 213 616 A2**
(43) Veröffentlichungstag der Anmeldung: **12.06.2002**
(21) Anmeldenummer: 01126755.6
(22) Anmeldetag: 09.11.2001
(51) Int. Cl.: G03F 1/00

(54) **Fotoempfindliches flexographisches Druckelement mit Polyether-Polyurethane umfassender IR-ablativer Schicht**

(30) Priorität: 07.12.2000 DE 10061114
(71) Anmelder: BASF Drucksysteme GmbH, 70469 Stuttgart (DE)
(72) Erfinder: Philipp, Sabine, Dr., 64546 Mörfelden-Walldorf (DE); Kaczun, Jürgen, Dr., 67150 Niederkirchen (DE)
(74) Vertreter: Wicke, Reinhard, Dr.

(57) **Zusammenfassung**

Fotoempfindliches Flexodruckelement zur Herstellung von Flexodruckformen durch digitale Bebilderung mittels Lasern, welches eine IR-ablative Schicht mit einem Polyetherpolyurethan als Bindemittel aufweist. Verfahren zur Herstellung von Flexodruckplatten unter Verwendung eines derartigen Elementes.

## Beschreibung

Die Erfindung betrifft ein fotoempfindliches Flexodruckelement zur Herstellung von Flexodruckformen durch digitale Bebilderung mittels Lasern, welches eine IR-ablative Schicht mit einem Polyetherpolyurethan als Bindemittel aufweist. Weiterhin betrifft die Erfindung ein Verfahren zur Herstellung von Flexodruckplatten unter Verwendung eines derartigen Elementes.

Die konventionelle Technik zur Herstellung von Flexodruckplatten durch Auflegen einer fotografischen Maske auf ein fotopolymeres Aufzeichnungselement, Bestrahlen mit aktinischem Licht durch diese Maske sowie Auswaschen der nicht polymerisierten Bereiche des belichteten Elementes mit einer Entwicklerflüssigkeit wird zunehmend durch CtP-Technologien (computer-to-plate-technology), häufig auch als digitale Bebilderung bezeichnet abgelöst. Bei CtP-Techniken wird die fotografische Maske konventioneller Systeme durch in das Aufzeichnungselement integrierte Masken ersetzt.

Obwohl eine Reihe verschiedener Techniken vorgeschlagen worden sind, haben bislang nur zwei Techniken am Markt größere Bedeutung erlangt. Bei der einen Technik wird das fotopolymerisierbare Element mit einer geeigneten Farbaufnahmeschicht versehen und eine Maske mittels eines Ink-Jet-Druckers aufgedruckt, wie beispielsweise offenbart von WO 97/25206. Anschließend kann das Element in bekannter Art und Weise belichtet und entwickelt werden.

Bei der zweiten Technik wird das fotopolymerisierbare Element mit einer weitgehend opaken, IR-ablativen Schicht beschichtet. Derartige Schichten enthalten üblicherweise Ruß. Durch bildmäßiges Bestrahlen mittels eines Lasers wird die IR-ablative Schicht an den Stellen entfernt, an denen sie vom Laserstrahl getroffen wird und die darunter liegende fotopolymerisierbare Schicht wird freigelegt. Danach kann das bebilderte Aufzeichnungselement durch die ablativ gebildete Maske in bekannter Art und Weise vollflächig mit aktinischem Licht bestrahlt und mit einer Entwicklerflüssigkeit ausgewaschen werden. Bei dem Auswaschschritt werden die nicht ablatierten Reste der IR-ablativen Schicht sowie die sich darunter befindlichen nicht polymerisierten Bereiche des belichteten Elementes entfernt.

Flexodruckelemente mit IR-ablativen Schichten sind prinzipiell bekannt. EP-A 654 150 offenbart ein flexografisches Druckelement mit einer IR-ablativen Schicht. Die IR-ablative Schicht umfasst ein IR-absorbierendes Material. Außerdem sind als optionale Bestandteile polymere Bindemittel sowie eine große Anzahl verschiedenster Hilfsmittel wie beispielsweise Dispergierhilfsmittel oder Weichmacher offenbart. Des Weiteren ist eine zusätzliche Sperrschicht zwischen der fotopolymerisierbaren Schicht und der IR-ablativen Schicht offenbart. Diese soll die Diffusion von Monomeren aus der fotopolymerisierbaren in die IR-ablative Schicht verhindern.

EP-A 741 330 offenbart ein IR-ablatives Flexodruckelement, welches keine derartige Sperrschicht aufweist. Als Bindemittel für die IR-ablative Schicht sind eine Vielzahl verschiedenster Polymere offenbart. Weiterhin kann die IR-ablative Schicht auch ein zweites Bindemittel in geringerer Menge umfassen, für das ebenfalls eine Vielzahl verschiedenster Polymerer offenbart sind.

EP-A 767 407 offenbart ein flexografisches Druckelement mit einer IR-ablativen Schicht, die ein elastomeres, filmbildendes Bindemittel aufweist. Als Bindemittel sind Polyamide sowie Polyvinylalkohol-Polyethylenglykol-Propfcopolymere offenbart.

Beim Verfahren zur Herstellung von Flexodruckplatten durch IR-Ablation ist die Qualität der IR-ablativen Schicht der entscheidende Parameter für die Qualität der Flexodruckplatte und der Wirtschaftlichkeit des Verfahrens. Die IR-ablative Schicht muss eine Reihe verschiedenster Qualitätskriterien erfüllen:
- Sie soll eine hohe Empfindlichkeit für Laser besitzen, um eine schnelle und vollständige Entfernung der Schicht bei möglichst geringer Laserleistung zu gewährleisten.
- Sie soll in konventionellen Auswaschmitteln für die fotopolymerisierbare Schicht löslich sein, damit sie im Zuge des üblichen Entwicklungsschrittes zusammen mit den nicht polymerisierten Bestandteilen der Schicht entfernt werden kann. Anderenfalls müssten zwei Auswaschschritte durchgeführt werden.
- Bei den heutzutage verwendeten Laserapparaturen handelt es sich üblicherweise um Geräte mit rotierenden Trommeln (Aussen- oder Innentrommel). Die IR-ablative Schicht muss daher elastisch sein, damit sie beim Aufspannen auf die Trommel nicht reisst oder runzelt.
- Sie muss klebfrei sein, damit kein Staub angezogen wird, der die IR-Ablation stören könnte.
- Für Lagerung und Transport werden Flexodruckelemente üblicherweise mit einer Schutzfolie vor Beschädigung geschützt, die vor der IR-Ablation abgezogen werden muss. Die Schutzfolie darf nur leicht an der IR-ablativen Schicht haften, damit beim Abziehen die IR-ablative Schicht nicht beschädigt wird.
- Umgekehrt muss die IR-ablative Schicht stark auf der lichtempfindlichen Schicht haften, damit sie beim Abziehen der Schutzfolie nicht mit abgezogen wird und damit keine Lufteinschlüsse den Vorteil des direkten Kontaktes zwischen IR-ablativer Schicht und fotopolymerisierbarer Schicht zunichte machen.

Der Fachmann, der ein hochempfindliches, qualitativ hochwertiges Flexodruckelement mit IR-ablativer Schicht bereitstellen möchte, sieht sich mit einer typischen Scherensituation konfrontiert. Um eine möglichst empfindliche IR-ablative Schicht zu erhalten, ist die Verwendung eines selbstoxidativen Bindemittels wie Nitrocellulose empfehlenswert. Nitrocellulose-Schichten sind aber sehr spröde, so dass die Elastizität von Nitrocellulose-Schichten zu wünschen übrig lässt und derartige Flexodruckelemente beim Aufspannen auf Trommelgeräte leicht runzeln. Zwar lässt sich die Sprödigkeit durch Zusatz von geeigneten Weichmachern vermindern, aber der Zusatz von Weichmachern hat häufig klebrige Schichten mit zu hoher Deckfolienhaftung zur Folge. Typische klebfreie Bindemittel, wie beispielsweise bestimmte Polyamide weisen jedoch eine deutlich geringere Empfindlichkeit auf.

Keines der zitierten Dokumente des Standes der Technik enthält einen Hinweis darauf, welche Komponenten man aus der Vielzahl möglicher Komponenten auswählen muss, um ein flexografisches Druckelement zu erhalten, welches alle geschilderten Anforderungen erfüllt.

Aufgabe der Erfindung war es, ein flexografisches Druckelement mit IR-ablativer Schicht bereitzustellen, welches die Nachteile des Standes der Technik nicht aufweist und die oben genannten Anforderungen erfüllt.

Dementsprechend wurde ein fotoempfindliches Flexodruckelement zur Herstellung von Flexodruckformen durch digitale Bebilderung mittels Lasern gefunden, welches mindestens
- einen dimensionsstabilen Träger,
- eine fotopolymerisierbare Schicht, mindestens umfassend ein elastomeres Bindemittel, eine polymerisierbare Verbindung und einen Fotoinitiator oder ein Fotoinitiatorsystem,
- eine laser-ablatierbare Schicht mit einer optischen Dichte im aktinischen Spektralbereich von mindestens 2,5, die mindestens ein elastomeres Bindemittel sowie einen IR-Absorber für Laserstrahlung aufweist, sowie
- optional eine abziehbare, flexible Schutzfolie,
umfasst, wobei es sich bei dem elastomeren Bindemittel in der IR-ablativen Schicht um ein elastomeres Polyetherpolyurethan handelt.

Weiterhin wurde ein Verfahren zur Herstellung von Flexodruckplatten unter Verwendung eines derartigen Elementes gefunden.

Zu der Erfindung ist im Einzelnen Folgendes auszuführen.

Bei dem erfindungsgemäßen fotopolymerisierbaren Druckelement ist eine übliche fotopolymerisierbare Schicht gegebenenfalls mit einer Haftschicht auf einem dimensionsstabilen Träger aufgebracht. Beispiele geeigneter dimensionsstabiler Träger sind Platten, Folien sowie konische und zylindrische Röhren (sleeves) aus Metallen wie Stahl oder Aluminium oder aus Kunststoffen wie Polyethylenterephthalat (PET) oder Polyethylennaphthalat (PEN).

Die fotopolymerisierbare Schicht besteht aus einem fotopolymerisierbaren Gemisch, welches negativ arbeitet, d.h. durch Belichtung gehärtet wird. Dies kann durch Fotovernetzung mit vorgefertigten Polymeren, durch Fotopolymerisation von niedermolekularen, fotopolymerisierbaren Verbindungen oder beides erfolgen. Fotopolymerisierbare Schichten umfassen im wesentlichen ein polymeres, im Entwickler auswaschbares elastomeres Bindemittel, eine ethylenisch ungesättigte, radikalisch polymerisierbare Verbindung, einen Fotoinitiator oder ein Fotoinitiatorsystem sowie optional weitere Additive und Hilfsstoffe. Die Zusammensetzung derartiger Schichten ist prinzipiell bekannt und beispielsweise in DE-A 24 56 439 oder EP-A 084 851 beschrieben.

Bei dem elastomeren Bindemittel kann es sich um ein einzelnes Bindemittel oder um ein Gemisch verschiedener Bindemittel handeln. Beispiele geeigneter Bindemittel sind die bekannten Vinylaromat/Dien-Copolymere bzw. Blockcopolymere, wie beispielsweise übliche SIS- oder SBS-Blockcopolymere, Dien/Acrylnitril-Copolymere, Ethylen/Propylen/Dien-Copolymere oder Dien/Acrylat/Acrylsäure-Copolymere. Beispiele geeigneter polymerisierbarer Verbindungen sind übliche ethylenisch ungesättigte Monomere wie Acrylate oder Methacrylate von mono- oder polyfunktionellen Alkoholen, Acryl- oder Methacrylamide, Vinylether oder Vinylester. Beispiele umfassen Butyl(meth)acrylat, 2-Ethylhexyl(meth)acrylat, Butandioldi(meth)acrylat oder Hexandioldi(meth)acrylat. Als Initiatoren für die Photopolymerisation sind aromatische beispielsweise Ketoverbindungen wie Benzoin oder Benzoinderivate geeignet.

Die fotopolymerisierbaren Gemische können ferner übliche Hilfsstoffe wie beispielsweise Inhibitoren für die thermisch initiierte Polymerisation, Weichmacher, Farbstoffe, Pigmente, fotochrome Zusätze, Antioxidantien, Antiozonantien oder Extrusionshilfsmittel umfassen.

Die genaue Zusammensetzung und die Dicke der fotopolymerisierbaren Schicht wird vom Fachmann je nach den jeweiligen Anforderungen bestimmt. Es können auch mehrere, übereinander angeordnete fotopolymerisierbare Schichten gleicher oder unterschiedlicher Zusammensetzung eingesetzt werden. Weiterhin kann das Element noch zusätzliche Schichten, wie beispielsweise Haftschichten, Oberschichten oder elastische Unterschichten umfassen.

Die fotopolymerisierbaren Schichten können je nach dem verwendeten Bindemittel wässrig oder organisch entwickelbar sein. Die Vorzüge der Erfindung kommen aber besonders zum Tragen, wenn es sich um eine organisch entwickelbare Schicht handelt.

Erfindungswesentliches Element ist die neuartige IR-ablative Schicht, die direkt oder auch indirekt, d.h. getrennt durch eine dünne Zwischenschicht wie beispielsweise eine Haft- oder eine Sperrschicht, auf der fotopolymerisierbaren Schicht aufgebracht ist. Bevorzugt ist die IR-ablative Schicht direkt auf der fotopolymerisierbaren Schicht aufgebracht.

Die IR-ablative Schicht umfasst mindestens ein elastomeres Bindemittel sowie einen IR-Absorber für Laserstrahlung und ist im wesentlichen opak für aktinische Strahlung. Im allgemeinen beträgt die optische Dichte der IR-ablativen Schicht im aktinischen Spektralbereich mindestens 2,5, vorzugsweise mindestens 3,0 und ganz besonders bevorzugt mindestens 3,5. Die besagte optische Dichte wird jeweils bei der Wellenlänge oder dem Wellenlängenbereich gemessen, der zur Belichtung des Elementes im Zuge der vollflächigen Bestrahlung eingesetzt wird.

Bei dem mindestens einen elastomeren Bindemittel handelt es sich um ein Polyetherpolyurethan. Geeignete Polyetherpolyurethane können in prinzipiell bekannter Art und Weise unter Verwendung von difunktionellen, mit Isocyanatgruppen zur Reaktion fähigen Polyethern, vorzugsweise Polyetherdiolen gebildet werden. Die difunktionellen Polyether werden mit vorzugsweise symmetrischen Diisocyanaten sowie kurzkettigen, niedermolekularen Diolen umgesetzt. Auf diese Art und Weise entstehen Polymere, die aus Hartund Weichsegmenten aufgebaut sind und elastomere Eigenschaften aufweisen. Nähere Einzelheiten zum Syntheseprinzip sind beispielsweise dargestellt in "Polyurethanes, Chapter 4.3; Ullmann's Encyclopedia of Industrial Chemistry, Sixth Edition, 2000 Electronic Release".

Geeignete Polyetherdiole zur Synthese der Polyetherpolyurethane weisen die allgemeine Formel HO-(Z-O-)ₓH auf. Es kann sich dabei um Homopolymere mit gleichartigen Z-Gruppen handeln, oder auch um Copolymere oder Blockcopolymere, die voneinander verschiedene Z-Gruppen in einem Molekül aufweisen. Bei den Z-Gruppen handelt es sich insbesondere um zweiwertige Reste, die sich von Ethylen, Propylen oder Butylen ableiten. Die Polyetherdiole können in prinzipiell bekannter Art und Weise durch Polymerisation von Ethylenoxid, Propylenoxid oder Butylenoxid unter Verwendung von Verbindungen, die über active H-Atome verfügen, wie beispielsweise Wasser oder Alkoholen erhalten werden. Sie können auch durch Polymerisation von cyclischen Ethern wie beispielsweise THF hergestellt werden. Es können auch Polyetherdiole eingesetzt werden, die noch geringe Mengen weiterer Kettenbausteine enthalten. Beispielhaft seinen Carbonatgruppen genannt, die durch Umsetzung von Polyalkylenoxiden mit Phosgen erhältlich sind. Die Menge derartiger zusätzlicher Bausteine sollte aber im Regelfalle 5 mol % bezüglich der Gesamtmenge der Kettenbausteine nicht überschreiten. Polyetherpolyurethane sind kommerziell erhältlich.

Die mittlere Molmasse M_{w} (Gewichtsmittel) der eingesetzten Polyetherpolyurethane beträgt üblicherweise 20 000 bis 200 000 g/ mol, bevorzugt 20 000 bis 150 000 g/mol und besonders bevorzugt 30 000 bis 130 000 g/mol.

Es können selbstverständlich auch Gemische zweier oder mehrerer unterschiedlicher Polyetherpolyurethane eingesetzt werden.

Die Menge an Polyetherpolyurethanen in der IR-ablativen Schicht beträgt im Regelfalle mehr als 40 bis maximal 90 Gew. % bzgl. der Menge aller Bestandteile der IR-ablativen Schicht, bevorzugt 45 bis 80 Gew. % und ganz besonders bevorzugt 45 bis 70 Gew. %.

Die IR-ablative Schicht umfasst weiterhin eine in der Schicht feinverteilte Substanz als Absorber für Laserstrahlung. Diese sollte eine möglichst hohe Absorption zwischen 750 und 20 000 nm aufweisen. Geeignete Substanzen als Absorber umfassen im IR absorbierende Farbstoffe wie beispielsweise Phthalocyanine und Phthalocyanin-Derivate, Merocyanine or Methin-Farbstoffe sowie stark gefärbte anorganische Pigmente wie beispielsweise Ruß, Graphit, Eisenoxide oder Chromoxide. Bevorzugt wird Ruß eingesetzt. Neben der Funktion als IR-Absorber gewährleistet Ruß gleichermaßen, dass die IR-ablative Schicht opak gegenüber aktinischer Strahlung ist, so dass es nicht unbedingt notwendig ist, zusätzlich einen UV-absorbierenden Farbstoff einzusetzen. Es ist bevorzugt, feinteilige Partikel einzusetzen, um eine möglichst maximale Farbstärke und eine möglichst gleichmäßige Schicht zu erhalten. Vorzugsweise werden feinteilige Rußsorten eingesetzt wie beispielsweise Printex® U, Printex® L6, Spezialschwarz 4 oder Spezialschwarz 250 von Degussa.

Die Menge an Absorber für die Laserstrahlung beträgt üblicherweise 1 bis 59,9 Gew. % bzgl. der Summe aller Bestandteile der Schicht, bevorzugt 10 bis 50 Gew. % und besonders bevorzugt 25 bis 50 Gew. %.

Die IR-ablative Schicht kann darüber hinaus auch noch zusätzliche Hilfsmittel oder Additive umfassen. Beispiel für derartige Hilfsmittel sind Dispergierhilfsmittel für Pigmente, Füllstoffe, Weichmacher oder Hilfsstoffe zur Beschichtung. Derartige Hilfsmittel oder Additive werden vom Fachmann je nach den gewünschten Eigenschaften der Schicht ausgewählt, vorausgesetzt, sie beeinflussen die Eigenschaften der Schicht nicht nachteilig. Geeignete Dispergierhilfsmittel für Ruße sind insbesondere Polyoxyalkylen-Derivate wie beispielsweise Solperse-Typen (Zeneca) oder Blockcopolymere wie Disperbyk-Typen (Byk). Es ist auch möglich, UV-Absorber als Hilfsmittel einzusetzen. Dies ist bei der Verwendung von Ruß als Absorber meist nicht unbedingt erforderlich, kann aber gelegentlich vorteilhaft sein. Bei Verwendung von IR-Farbstoffen als Absorber ist der Einsatz von zusätzlichen UV-Absorbern häufig nicht zu vermeiden, wenngleich auch nicht in jedem Falle zwingend erforderlich. Im Regelfalle sollte die Menge aller Additive und Hilfsstoffe 20 Gew. %, bevorzugt 10 Gew. % und ganz besonders bevorzugt 5 Gew. % bezüglich der Summe aller Bestandteile der IR-ablativen Schicht nicht überschreiten.

Alle Bestandteile der IR-ablativen Schicht sollten weiterhin so gewählt werden, dass die IR-ablative Schicht in üblichen organischen Entwicklern für flexografische Druckplatten vollständig löslich oder zumindest quellbar sind, so dass die Reste der IR-ablativen Schicht in einem Arbeitsgang zusammen mit den nicht polymerisierten Bereichen der fotopolymerisierbaren Schicht entfernbar sind. Die Erfindung ist aber nicht auf diese Ausführungsform beschränkt.

Es ist empfehlenswert, das erfindungsgemäße IR-ablative Flexodruckelement durch eine flexible Schutzfolie vor Beschädigung bei Transport, Lagerung und Handling zu schützen, obgleich eine derartige Schutzfolie nicht unbedingt erforderlich ist.

Die IR-ablative Schicht sollte möglichst dünn sein, damit sie so effizient wie möglich mittels Laserstrahlung entfernbar ist. Die Dicke der Schicht ist nach unten hin nur insofern beschränkt, als die Schicht eine optische Dichte von mindestens 2,5 aufweisen muss. Im Regelfalle ist eine Dicke von 1 bis 10 µm sinnvoll, ohne dass die Erfindung damit auf diesen Bereich beschränkt werden soll.

In einer besonders vorteilhaften Ausführungsform umfasst die IR-ablative Schicht neben dem Polyetherpolyurethan oder den Polyetherpolyurethanen mindestens ein weiteres Bindemittel anderer chemischer Natur, welches im Folgenden als sekundäres Bindemittel bezeichnet werden soll. Es können auch mehrere voneinander verschiedene Bindemittel als sekundäres Bindemittel eingesetzt werden. Die Menge des sekundären Bindemittels ist geringer als die Menge des Hauptbindemittels Polyetherpolyurethan. Die Menge eines derartigen sekundären Bindemittels beträgt üblicherweise 0 bis 40 Gew. %, bevorzugt 0 bis 20 Gew. % und besonders bevorzugt 0 bis 10 Gew. % bzgl. aller Bestandteile der IR-ablativen Schicht.

Das sekundäre Bindemittel wird vom Fachmann je nach den gewünschten Eigenschaften der IR-ablativen Schicht ausgewählt, vorausgesetzt, die Eigenschaften der Schicht werden durch das sekundäre Bindemittel nicht negativ beeinflusst.

Besonders bewährt als sekundäre Bindemittel neben dem Polyetherpolyurethan haben sich Cellulose-Derivate, die beispielsweise durch Veresterung oder Veretherung von Cellulose erhalten werden können. Beispiele geeigneter Cellulose-Derivate umfassen Methylcellulose, Ethylcellulose, Hydroxyethylcellulose, Hydroxypropylcellulose, Celluloseactetat, Celluloseacetylpropionat, Celluloseacetylbutyrat, Nitrocellulose oder Gemische davon. Ganz besonders bewährt haben sich sowohl Nitrocellulose als auch Ethylcellulose.

Die erfindungsgemäßen fotoempfindlichen Flexodruckelemente können hergestellt werden, indem man zunächst die fotopolymerisierbare Schicht und optional weitere Schichten auf den Träger aufbringt, und anschließend die IR-ablative beispielsweise durch Aufgießen oder Auflaminieren aufträgt. Hierzu werden zunächst alle Bestandteile der Schicht unter intensivem Mischen in einem geeigneten Lösungsmittel oder Lösungsmittelgemisch gelöst oder dispergiert. Eine derartige Lösung bzw. Dispersion kann direkt auf das fotopolymerisierbare Element aufgebracht und das Lösemittel verdampft werden. Die Lösung kann aber auch auf eine Trägerfolie, wie beispielsweise eine PET-Folie gegossen und das Lösemittel verdampft werden. Danach wird der beschichtete Träger unter Druck und/oder Wärmeeinfluss auf die fotopolymerisierbare Schicht laminiert. Der Träger für die IR-ablative Schicht fungiert nun als Schutzfolie für das gesamte fotopolymerisierbare Druckelement.

Die erfindungsgemäßen fotoempfindlichen Druckelemente mit IR-ablativer Schicht werden zur Herstellung von Flexodruckplatten eingesetzt. Falls vorhanden wird zunächst die Schutzfolie abgezogen. Danach wird die IR-ablative Schicht bildmäßig mit einem geeigneten Laser bestrahlt um eine fotografische Maske zu erhalten. Beispiele geeigneter IR-Laser umfassen Nd/YAG-Laser (1064 nm) oder Dioden-Laser (z.B. 830 nm). Geeignete Lasersysteme für computerto-plate-Technologie sind kommerziell erhältlich, z.B. das Dioden-Lasersystem OmniSetter® (Fa. Misomex, Wellenlänge 830 nm; Arbeitsbreite 1800 mm) oder das Nd/YAG-Laser-system digilas® (Fa. Schepers) welches jeweils eine zylindrische Trommel umfasst, auf welche das flexografische Druckelement mit IR-ablativer Schicht montiert wird. Die Trommel wird anschließend in Rotation versetzt und das Element mittels des Laserstrahl bebildert.

Nach Einschreiben der Maske wird das fotoempfindliche Element vollflächig mit aktinischem Licht durch die Maske hindurch belichtet. Dies kann vorteilhaft direkt auf dem Laserzylinder erfolgen. Die Platte kann aber auch abmontiert und in einer konventionellen Flachbett-Belichtungsapparatur -an Luft, unter Stickstoff oder im Vakuum- belichtet werden. Im Zuge des Belichtungsschrittes wird die Schicht an solchen Stellen, die im vorangehenden Verfahrensschritt durch IR-Ablation freigelegt wurden, fotochemisch vernetzt, während die nach wie vor abgedeckten Stellen unvernetzt bleiben.

In einem weiteren Verfahrensschritt wird das belichtete Element entwickelt. Das Entwickeln kann prinzipiell in handelsüblichen Entwicklerapparaturen unter Verwendung handelsüblicher organischer Auswaschmittel für Flexodruckplatten wie beispielsweise nylosolv® oder Optisol® durchgeführt werden. Im Zuge der Entwicklung werden die nicht belichteten Anteile der fotopolymerisierbaren Schicht sowie die Reste der IR-ablativen Schicht entfernt.
Es wird bevorzugt nur ein einziges Auswaschmittel für diesen Verfahrensschritt eingesetzt. Es ist aber auch möglich, zunächst die Reste der IR-ablativen Schicht mit einem Auswaschmittel zu entfernen und anschließend die Platte in einem zweiten Auswaschmittel zu entwickeln. Nach dem Entwickeln werden die erhaltenen Flexodruckplatten in bekannter Art und Weise getrocknet. Das Verfahren kann weitere Verfahrensschritte, wie beispielsweise eine Entklebung mit UV-C oder Br₂ umfassen.

Die erfindungsgemäßen Flexodruckelemente mit IR-ablativer Schicht weisen eine Reihe von Vorteilen auf:

Die Empfindlichkeit für Laserstrahlung erreicht zwar nicht die von reinen Nitrocellulose-Schichten, ist aber dennoch höher als die der meisten kommerziell erhältlichen Platten. Die Schichtoberfläche ist klebfrei und die Schutz- bzw. Deckfolienhaftung gering, so dass die Schutzfolie ohne Probleme angezogen werden kann. Die Haftung auf der fotopolymerisierbaren Schicht ist andererseits groß genug, so dass die IR-ablative Schicht auch bei schnellem und unvorsichtigem Abziehen der Schutzfolie auf der fotopolymerisierbaren Schicht haften bleibt. Die Schichten sind mit üblichen organischen Auswaschmitteln wie bspw. nylosolv® abwaschbar. Besonderns vorteilhaft ist die überraschend hohe Elastizität, so dass derartige Flexodruckplatten problemlos um die Trommeln von Laserbelichtern gelegt werden können, ohne dass die Schicht reisst oder runzelt.

Die folgenden Beispiele sollen die Erfindung beispielhaft erläutern.

Allgemeine Vorschrift zur Herstellung einer Dispersion von IR-Absorber und Bindemittel

Das Dispergierhilfsmittel (Solsperse 20 000) wird im Lösemittelgemisch vorgelöst. Anschließend werden das/die Bindemittel sowie gegebenenfalls weitere Additive zugegeben und unter Rühren gelöst. Dann wird der Ruß langsam zugegeben und 15 min bei einer Geschwindigkeit von 5000 U/min am Dissolver eindispergiert. Die erhaltene Mischung wird 1h in einer Laborrührwerkskugelmühle gemahlen. Die Dispersion hat einen Feststoff-Gehalt von 10 Gew. % bezüglich der Summe aller Bestandteile.

Die Dispersion wird am Laborrakel auf eine PET-Folie aufgerakelt und 10 min bei 60 °C getrocknet. Die Auftragsmenge wird so bemessen, dass ein ca. 2.5 µm dicker trockener Film entsteht. Die optische Dichte eines derartigen Films im Spektralbereich des aktinischen Lichts beträgt 3.0 bis 3.5.

Von einer kommerziellen Flexodruckplatte vom Typ FAH 254 (BASF) wird die Schutzfolie und die Substratschicht entfernt, so dass die Oberfläche der fotopolymerisierbaren Schicht freigelegt ist. Die mit der IR-ablativen Schicht beschichtete Folie wird auf die Oberfläche der fotopolymerisierbaren Schicht trocken aufkaschiert, so dass die IR-ablative Schicht und die fotopolymerisierbare Schicht miteinander verbunden werden. Die PET-Folie bildet die Schutzfolie. Die Platte lagert 1 Woche bei Raumtemperatur.

### Beispiele 1 - 5:

Es wurde jeweils ein Polyetherpolyurethan als Bindemittel sowie bei einigen Versuchen ein 2. Bindemittel eingesetzt. Die Mengen der jeweiligen Einsatzstoffe sind in Tabelle 1 angegeben.

Von den erhaltenen Platten wurden die Deckfolienhaftung, die Substrathaftung, die Elastizität und die Klebrigkeit der IR-ablativen Schicht bestimmt. Die Messvorschriften für die Messgrößen sind in Tabelle 3 aufgeführt, die Ergebnisse in Tabelle 2 zusammengefasst.

### Vergleichsbeispiele V1 - V 5:

Es wurden andere Bindemittel als Polyetherpolyurethane eingesetzt. Die Mengen der jeweiligen Einsatzstoffe sind in Tabelle 1 angegeben.

Von den erhaltenen Platten wurden die Deckfolienhaftung, die Substrathaftung, die Elastizität und die Klebrigkeit der IR-ablativen Schicht bestimmt. Die Messvorschriften für die Messgrößen sind in Tabelle 3 aufgeführt, die Ergebnisse in Tabelle 2 zusammengefasst.

Bebilderung mittels Laser, Verarbeitung zur Flexodruckplatte, allgemeine Vorschrift

Die PET-Schutzfolie der Flexodruckelemente mit IR-ablativer Schicht wird entfernt und die Platte auf die rotierbare Trommel (Durchmesser: 0,25 m) eines Nd-YAG-Lasersystemes (Fa Schepers/ Ohio, digilas®) montiert. Die Trommel wird bis auf 1600 Upm beschleunigt. Der Laservorschub beträgt 10 µm pro Trommelumdrehung.

In einem ersten Versuch wird bei jeder Platte zunächst die Laserleistung ermittelt, die bei besagter Drehzahl und Vorschub zum vollständigen Entfernen der IR-ablativen Schicht an den Stellen, an denen sie vom Laserstahl getroffen wird, mindestens erforderlich ist. Aus der notwendigen Laserleistung lässt sich die Empfindlichkeit der Platte in J/m² berechnen; also die Mindestenergie pro Fläche, die zur Entfernung der Schicht erforderlich ist. Die Empfindlichkeit ist umso höher, je kleiner die Mindestenergie ist.

In einem weiteren Versuch wird jede Platte mit der ermittelten Laserleistung digital bebildert. Das erhaltene fotopolymerisierbare Flexodruckelement mit digitaler Maske wird 15 min mit aktinischem Licht in konventioneller Art und Weise bestrahlt und anschließend in konventioneller Art und Weise in einem Bürstenwascher unter Verwendung des kommerziellen (organsischen) Auswaschmittels nylosolv® II entwickelt. Nach dem Entwickeln wird die Platte für 2 Stunden bei 60°C getrocknet, mit UV-C-Licht zur Entklebung bestrahlt und schließlich für 10 min mit aktinischem Licht nachvernetzt.

### Beispiele 1 - 5 und Vergleichsbeispiele V1 - V5

Es wurden jeweils die hergestellten flexografischen Druckelemente eingesetzt. Die jeweils ermittelte Laserleistung bzw. die Empfindlichkeit ist in Tabelle 2 angegeben. Weiterhin wurde die Abwaschbarkeit bzw. Entfernbarkeit der IR-ablativen Schicht im Auswaschmittel ermittelt. Die Ergebnisse sind in Tabelle 2 aufgeführt, die Messverschrift ist in Tabelle 3 enthalten.

### Vergleichsbeispiele V 6 - V 9

Von 4 kommerziell erhältlichen Flexodruckelementen mit IR-ablativer Schicht wurden wie oben geschildert die mechanischen Eigenschaften, die Empfindlichkeit und die Verarbeitungseigenschaften ermittelt. Die Ergebnisse sind ebenfalls in Tabelle 2 aufgeführt.

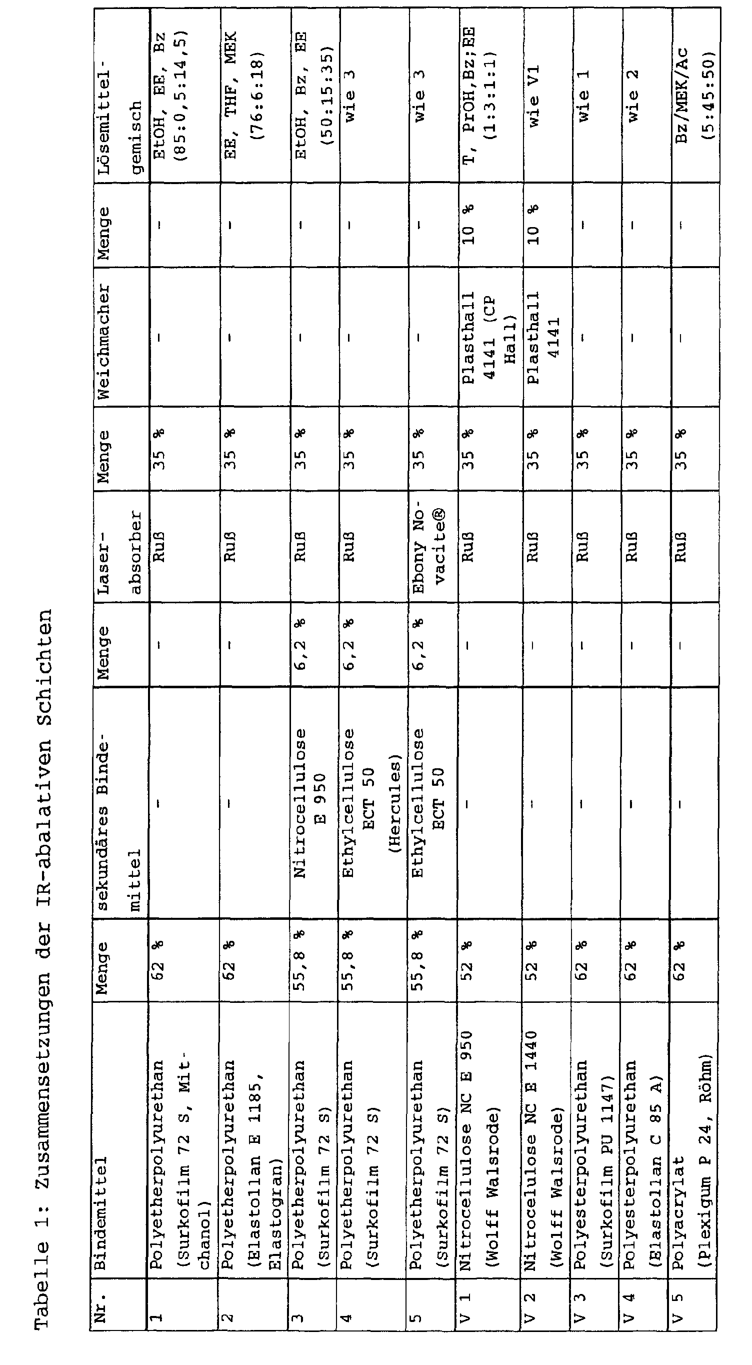

Mengenangaben jeweils in Gew.% bzgl. aller Bestandteile der Schicht, bei allen Versuchen noch jeweils 3 Gew. % Solperse 2000 als Disperpierhilfsmittel,
Das Verhältnis von Feststoffen zum Lösungsmittel in der Dispersion beträgt 1:9
(Abkürzungen: EtOH: Ethanol, PrOH: 1-Propanol EE Essigester, Bz: Benzylalkohol, Ac: Aceton, MEK: Methylethylketon, T: Toluol)

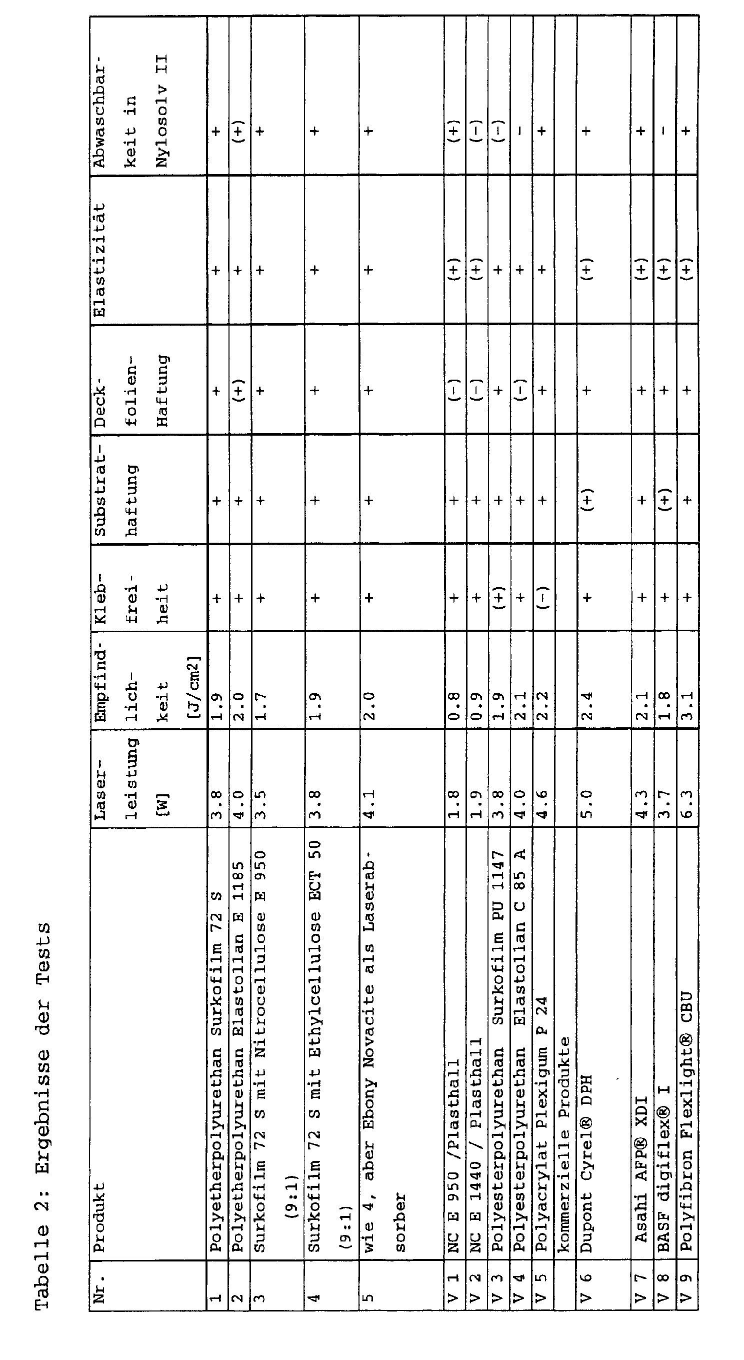

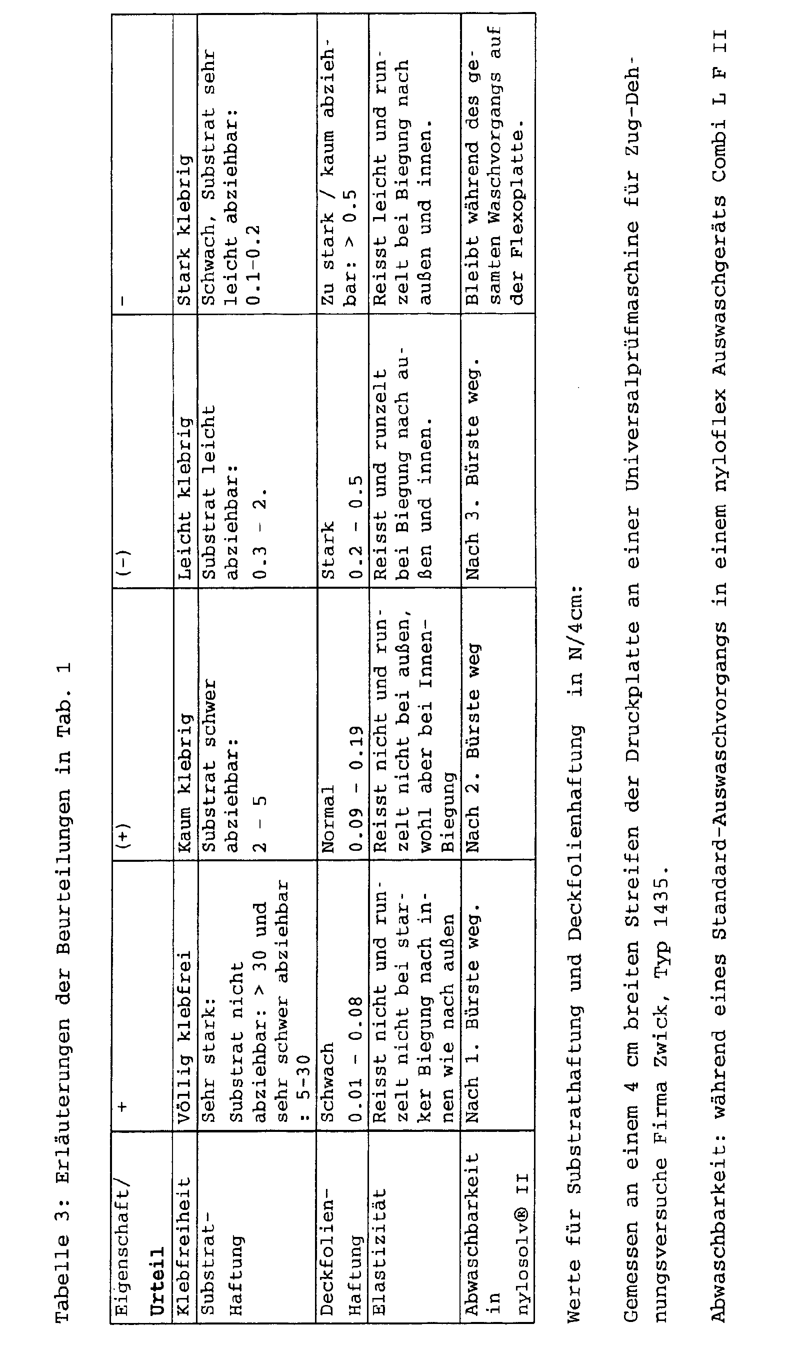

## Patentansprüche

1. Fotoempfindliches Flexodruckelement zur Herstellung von Flexodruckformen durch digitale Bebilderung mittels Lasern, mindestens umfassend
• einen dimensionsstabilen Träger,
• eine fotopolymerisierbare Schicht, mindestens umfassend ein elastomeres Bindemittel, eine polymerisierbare Verbindung und einen Fotoinitiator oder ein Fotoinitiatorsystem,
• eine laser-ablatierbare Schicht mit einer optischen Dichte im aktinischen Spektralbereich von mindestens 2,5, die mindestens ein elastomeres Bindemittel und einen IR-Absorber für Laserstrahlung aufweist, sowie
optional eine abziehbare, flexible Schutzfolie,
**dadurch gekennzeichnet, dass** es sich bei dem elastomeren Bindemittel der laser-ablatierbaren Schicht um ein elastomeres Polyetherpolyurethan handelt.

2. Fotoempfindliches Flexodruckelement gemäß Anspruch 1, **dadurch gekennzeichnet, dass** die Menge des Polyetherpolyurethans in der laser-ablatierbaren Schicht mehr als 40 bis maximal 90 Gew. % umfasst.

3. Fotoempfindliches Flexodruckelement gemäß Anspruch 1 oder 2, **dadurch gekennzeichnet, dass** die laser-ablatierbare Schicht mindestens ein weiteres, vom elastomeren Polyetherurethan verschiedenes Bindemittel umfasst, wobei die Menge des mindestens einen weiteren Bindemittels geringer ist als die des Polyetherpolyurethans.

4. Fotoempfindliches Flexodruckelement gemäß Anspruch 3, **dadurch gekennzeichnet, dass** es sich bei dem zweiten Bindemittel um ein Cellulose-Derivat handelt.

5. Fotoempfindliches Flexodruckelement gemäß Anspruch 4, **dadurch gekennzeichnet, dass** es sich bei dem zweiten Bindemittel um ein Cellulose-Derivat, ausgewählt aus der Gruppe von Methylcellulose, Ethylcellulose, Hydroxyethylcellulose, Hydroxypropylcellulose, Celluloseactetat, Celluloseacetylpropionat, Celluloseacetylbutyrat, oder Nitrocellulose handelt.

6. Fotoempfindliches Flexodruckelement gemäß einem der Ansprüche 3 bis 5, **dadurch gekennzeichnet, dass** die laser-ablatierbare Schicht 1 - 40 Gew. % des zweiten Bindemittels umfasst.

7. Fotoempfindliches Flexodruckelement gemäß einem der Ansprüche 1 bis 6, **dadurch gekennzeichnet, dass** es sich bei dem IR-Absorber um Russ handelt.

8. Fotoempfindliches Flexodruckelement gemäß einem der Ansprüche 1 bis 7, **dadurch gekennzeichnet, dass** das elastomere Polyetherpolyurethan eine mittlere Molmasse M_{w} von 20 000 g/mol - 200 000 g/mol aufweist.

9. Verfahren zur Herstellung einer flexografischen Druckform, bei der man als Ausgangsmaterial ein fotoempfindliches Flexodruckelement nach einem der Ansprüche 1 - 8 einsetzt, umfassend die folgenden Schritte:
a) Entfernen der abziehbaren, flexiblen Schutzfolie, falls vorhanden,
b) Einschreiben einer Maske in die IR-ablative Schicht mittels eines IR-Lasers,
c) vollflächiges Belichten des fotoempfindlichen Elementes mit aktinischem Licht durch die in Schritt (b) gebildete Maske,
d) Behandeln des in (c ) gebildeten Zwischenproduktes mit zumindest einer Entwickler-Lösung, wobei die Reste der IR-ablativen Schicht, die im Schritt (b) nicht entfernt worden sind entfernt und werden belichtete, fotopolymerisierbare Schicht entwickelt wird.

10. Verfahren gemäß Anspruch 9, **dadurch gekennzeichnet, dass** man zur Durchführung des Schrittes (b) eine Laserapparatur mit einer rotierenden Trommel verwendet und das flexografische Druckelement zum Ablatieren auf diese Trommel montiert wird.
